(19) Europäisches Patentamt
European Patent Office
Office européen des brevets

(11) Publication number: 0 319 008 A2

(12) # EUROPEAN PATENT APPLICATION

(21) Application number: 88120096.8

(22) Date of filing: 01.12.88

(51) Int. Cl.⁴: C08G 59/40 , C08L 63/00 , B32B 7/00

(30) Priority: 01.12.87 US 127353

(43) Date of publication of application: 07.06.89 Bulletin 89/23

(84) Designated Contracting States: BE DE ES FR GB IT NL SE

(71) Applicant: HERCULES INCORPORATED
Hercules Plaza
Wilmington Delaware 19894(US)

(72) Inventor: Chu, Sun Gun
3530 Hopkins Road
Wilmington Delaware 19808(US)
Inventor: Jabloner, Harold
527 Cherry Street
Wilmington Delaware 19720(US)
Inventor: Nguyen, Tuyen Thanh
6008 Stone Pine Road/The Pines
Wilmington Delaware 19808(US)

(74) Representative: Lederer, Franz, Dr. et al
Van der Werth, Lederer & Riederer
Patentanwälte Lucile-Grahn-Strasse 22
D-8000 München 80(DE)

(54) **Epoxy resin compositions as used in producing composites with high wet glass transition temperatures and in adhesive applications.**

(57) Thermosetting epoxy resin compositions, comprising a polyfunctional epoxy resins, dianhydride or diamine hardeners, and amide, imide, or amideimide oligomers,and their uses in making adhesives, or thermoset composites that exhibit a critical stress intensity factor ($K_{1C}$) greater than 1.0 MPam$^{1/2}$ while maintaining a wet $T_g$ greater than about 120° C upon curing in the presence of inorganic or organic fibers, are described; the oligomers are terminated with amine, isocyanate or carboxylic acid derivative groups, have a number average moleculer weight from about 1000 to about 50,000 and a glass transition temperature of above about 150° C, while being soluble in the combination of the epoxy resin and the hardener at a temperature under about 150° C.

EP 0 319 008 A2

# EPOXY RESIN COMPOSITIONS AS USED IN PRODUCING COMPOSITES WITH HIGH WET GLASS TRANSITION TEMPERATURES AND IN ADHESIVE APPLICATIONS

This invention relates to new thermosetting epoxy resin compositions that contain reactive aromatic oligomers and are useful in the preparation of composites comprising high strength filaments and thermoset resin matrices which have high glass transition temperatures ($T_g$ greater than about 200° C) and high wet glass transition temperatures ($T_g$ greater than about 175° C). This invention also relates to composites, prepared from the thermosetting epoxy compositions, which exhibit high fracture toughness, $K_{IC}$ greater than 1.0 $MPam^{1/2}$ while maintaining a wet $T_g$ greater than about 175° C. Further, this invention relates to thermosetting epoxy resin compositions useful as adhesives, especially in bonding polyimides to copper.

Epoxy resins are well known for use in making advanced or high performance composites comprising high strength fiber made of glass, boron, carbon, or the like. (Epoxy resin, as the term is used herein, means compounds having at least about two epoxy groups per molecule.) Structures made of such composites can weigh considerably less than their metal counterparts at equivalent strength and stiffness. Epoxy composites, particularly those with high glass transition temperatures, however, have been relatively brittle. In addition, epoxy composites having high wet glass transition temperatures (a measure of weatherability) as well as high modulus have not been disclosed in the prior art. (Wet glass transition temperature is a measure of the hot wet properties (high impact strength under high moisture conditions.)) These properties are especially useful in aircraft applications where the formed parts are subject to weathering and changes in temperature and moisture conditions. The brittleness and low wet glass transition temperature restricts the wider application of conventional epoxy resin compositions.

An approach for improving the the toughness of a composite comprising a crosslinked epoxy resin by the addition of oligomers is described in U.S. Patents 4,656,207 and 4,656,208.

Still another approach for improving the toughness of crosslinked epoxy resins is described in U.S. Patent 4,661,559. Gardner et al disclose the use of a diamine hardener, and epoxy resin, and a thermoplastic polymer where a disclosed useful thermoplastic polymer is a polyarylether.

Specific polyetheramide-imide epoxy resin blends have been disclosed in the prior art as for example in U.S 4,118,535. However, these compositions are for dry powder applications especially for wire coating applications. The process of reacting an epoxy resin with a amino terminated polyimide without the presence of a hardener has been disclosed in the prior art for example in U.S. Patent 4,277,583. These compositions have melting points above 80° C and are soluble in only aprotic solvents or mixtures thereof.

The use of rubber polymers in epoxy resin composites is shown in U.S. Patents 3,837,904, 3,926,903, and 3,926,904 and in U.S. Application 884,139 filed July 9, 1986.

Methods to improve the wet glass transition temperature of epoxy resins while at the same time reducing the brittleness of these resins has not heretofore been disclosed.

The use of epoxy resins to bond a metal foil to a polyimide film has been disclosed as for example in U. S. Patent 4,626,474. In addition, the use of an epoxy resin containing a methyl methacrylate-glycidyl methacrylate copolymer to bond polyimide films and metal foils has been shown as for example in U. S. Patent 3,717,543. Further, U. S. 3,904,813 describes the use of an adhesive composition containing an epoxy resin and a carboxyl-terminated polymer to bond polyimide film and metal foil. None of the above patents describes adhesive compositions containing an epoxy resin and a polyimide oligomer.

Now, in accordance with a first embodiment of this invention, it has been found that thermosetting epoxy resin compositions comprising (a) aromatic epoxy resins having at least two epoxy groups per molecule, (b) hardeners selected from dianhydrides or diamines, and (c) amine, isocyanate or carboxylic acid derivative, i.e. acid halide, preferable chloride, anhydride, acid, or isocyanate terminated amide, imide, or amideimide oligomers having glass transition temperatures, $T_g$ above about 200° C, molecular weights about 3,000 to about 10,000, and which are soluble in combination with the epoxy resin and hardener below about 80° C, yield upon curing in the presence of inorganic or organic fibers, thermoset composites. These thermoset composites have improved wet glass transition temperatures and thus improved hot wet properties under high moisture conditions. The cross-linked thermosetting epoxy compositions (thermosets or, when cured, a matrix resin) preferably exhibit multiphase morphology in which two or more glassy phases of the matrix resin may be observed microscopically.

In a second embodiment of this invention, the thermosetting epoxy resin composition is an adhesive comprising an aromatic epoxy resin, hardeners selected from dianhydrides or diamines and amine, isocyanate or carboxylic acid derivative terminated amide, imide, or amideimide oligomers having glass transition temperatures, $T_g$, above about 200° C, molecular weights about 5,000 to about 50,000, and which

are soluble in combination with the epxoy resin and hardener below about 80 °C yield, upon curing, adhesives. The adhesives are especially useful in bonding polyimides to copper foil or metal where peel strengths of greater than three pounds per inch width are desirable. The cured adhesives are also resistant to degradation by moisture.

. The thermosetting epoxy composition of this invention is prepared by combining an epoxy resin having the formula,

(I)

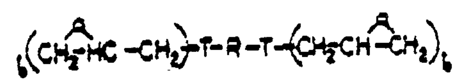

an aromatic diamine or dianhydride hardener, an amine, isocyanate, anhydride, acid or acid chloride or mixture thereof terminated oligomer and optionally a functionally substituted rubber. The composition may also contain an epoxy resin or combination thereof of higher molecular weight as defined by formulae

(II)

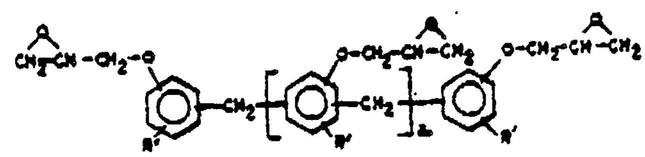

(III)

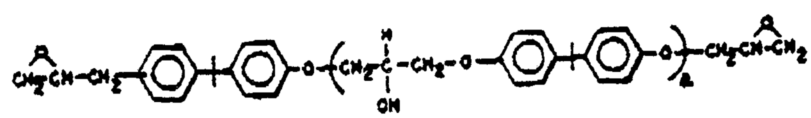

In formula I above R is divalent aryl, diaryl, or alkylaryl; T is oxygen, nitrogen, or ester and can be the same or different, and b is one if T is oxygen or ester $(-O\overset{O}{\overset{\parallel}{C}}-)$ and two if T is nitrogen. In formulae II and III , a is 0 to 10 and $R^1$ is hydrogen or methyl. When epoxy resins of the type of formula I are used, liquids at room temperature result. When structures of the type II and III are used, compositions which are pastes at room temperature, but liquid below about 80 °C, result.

The hardener is an aromatic diamine or dianhydride preferably selected from the formulae

(IV)

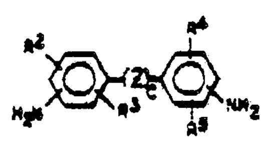

(V)

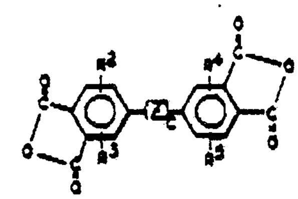

where $R^2$, $R^3$, $R^4$, $R^5$ are independently hydrogen, halogen or an alkyl or alkoxy group with 1 to 12 carbon atoms and Z is -O-,-S-,$-SO_2-$, -CO-, alkylene, alkylidene, oxoalkylene, phenylene diamine, a heterocyclic diamine, a phenylene dioxide, a diphenylene dioxysulfone, a dioxydiphenylpropane, or a diphenyloxydisulfone, and the like, and c is 0 or 1. The anhydride groups shown are not meant to limit positions the anhydride groups can have, but merely to show that the carboxyl groups are attached to adjacent carbon atoms. Other useful aromatic diamines and dianhydrides are well known in the art.

The amine, isocyanate, anhydride, acid, acid chloride or mixture thereof terminated oligomer is prepared by reacting a diamine or mixture thereof or diisocyanate and a material selected from a dianhydride, a diacid chloride, a diacid, an anhydride-acid chloride, an anhydride-acid or mixtures thereof. The resulting oligomer has terminal amine groups, isocyanate groups or carboxyl acid derivative (acid, anhydride, or acid chloride) groups. Terminal amine groups on the oligomer result from employing a molar excess of diamine in the reaction. Terminal isocyanate groups on the oligomer result from employing a

molar excess of diisocyanate in the reaction. Diisocyanates are reacted only with dianhydrides to yield imide oligomers. Terminal carboxylic acid derivative groups result from employing a molar excess of the dicarboxylic acid derivative reactant in the reaction. Depending on the choice of dicarboxylic acid derivative chosen, imide, amide, amideimide oligomers are produced. In the preferable embodiments of this invention amine end groups are preferred when the epoxy hardener has amine groups and carboxylic acid derivatives are preferred when the epoxy hardener has dianhydride end groups. Isocyanate terminated materials can be used with epoxy hardeners having either amine or anhydride end groups. However, it is possible to use an oligomer having amine end groups with a dianhydride epoxy hardener or a carboxylic acid derivative terminated oligomer with a diamine epoxy hardener. Isocyanate terminated materials can be used with epoxy hardeners having either amine or anhydride end groups. In the latter two instances, it is possible that the oligomer and hardener react together instead of only reacting with the epoxy resin as in the case when like end groups are used in both the oligomer and epoxy hardener.

Amines employed in preparing the amine or carboxylic acid derivative oligomers are alkylaryl diamines having the formulas,

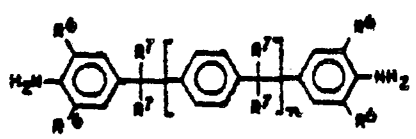

(VI)

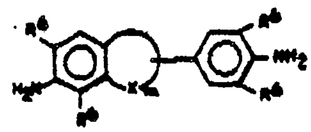

(VII)

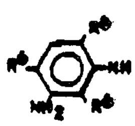

(VIII)

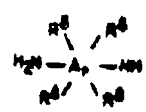

(IX)

In formulas (VI), (VII), (VIII), and (IX) above $R^6$ is an alkyl, aryl, alkylaryl, halogen or hydrogen; $R^7$ is methyl or lower alkyl; n is 0 to 4; X is methylene and m is 3 to 6; Ar is an aryl or alkylaryl such as naphthalene, biphenyl, phenanthrene, 2,2-diphenyl hexafluoropropyl and the like, and $R^8$ is alkyl, aryl, aryl, arylalkyl, or halogen and the four $R^8$ groups are on adjacent carbon atoms to the two amine groups and such $R^8$ groups may be the same or different. Diisocyanates which can be employed are diisocyanate derivatives of the amines mentioned above in which an isocyanate (NCO) replaces each amine ($NH_2$) group in any of the compounds of formula VI, VII, VIII and IX.

Dianhydrides; diacid chlorides or diacids; or acid anhydride acid chlorides or acid anhydride acids or mixtures thereof which can be used in preparing the terminally substituted diamine diisocyanate or acid derivative oligomers are of the aryl or alkylaryl type and are well known in the art, and in general, are chosen from the structures shown in formulas X, XI, XII

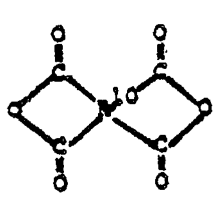

(X)

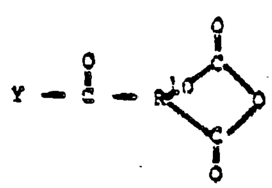

(XI)

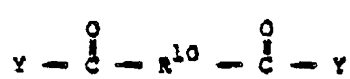

(XII)

where $R^{10}$ is aryl, alkylaryl, or diaryl where the aryl groups are connected through

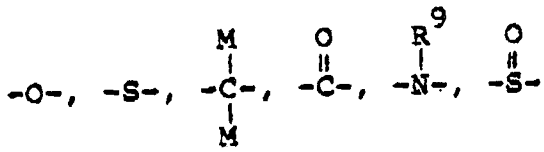

where M is an alkyl or haloalkyl radical, Y is a halogen or hydroxy group and $R^9$ is a hydrogen, lower alkyl and the carboxyl groups of the anhydride groups are attached directly to separate carbon atoms and each carboxyl group of the anhydride group is attached to adjacent carbon atoms in the $R^{10}$ radical.

When an excess mole ratio of diamine or mixture thereof or diisocyanate is used in relation to the mole ratio of (i) dianhydride; (ii) diacid chloride or diacid; (iii) acid anhydride-acid chloride or acid or (iv) a mixture thereof is used in preparing an oligomer, an oligomer having amine or isocyanate end groups respectively results. When the afore mentioned (i) dianhydride, (ii) diacid chloride or diacid, (iii) or acid anhydride acid chloride or acid or (iv) mixture thereof are used in excess in relation to the aforementioned diamine or mixture thereof or diisocyanate, an oligomer with anhydride, acid chloride, or acid groups or mixture thereof of end groups results. As stated previously, diisocyanates are only reacted with dianhydrides to give imide type oligomers.

In the case where the oligomer is to be used for adhesive purposes and a higher molecular weight is desired, i.e. a preferred molecular weight of about 30,000 to 40,000 number average, an equal molar ratio of diamine or mixture thereof or diisocyanate to (i) dianhydride, (ii) diacid chloride or diacid, (iii) or acid anhydride-acid chloride or acid or (iv) mixture thereof is used. In this case it is possible for a mixture of amine or isocyanate with acid, acid chloride or anhydride end groups to result.

Functionalized rubbers can optionally be added to the compositions of this invention. Generally about 1 to about 10 weight percent, preferably about 5 to about 7 weight percent of the rubber is added. These functionalized rubbers are defined as materials which are elastomeric and contain functional groups such as carboxylic acids, amines, alcohols, or thiols which react with the epoxide, anhdydride, isocyanate, acid, acid chloride, or amine groups of the epoxy resin, epoxy hardener, or oligomer. The rubber may be liquid or solid. If solid the rubber is generally not soluble in the epoxy resin composition of this invention and is therefore dispersed in the composition. If liquid the functionalized rubber is generally soluble in the compositions of this invention. In addition to the use of functionalized rubbers the use of glasses or ceramic materials may be dispersed in the compositions of this invention. The use of rubbers and fillers such as glass and ceramics generally give rise to tougher materials than when these materials are not present.

The thermosetting compositions of this invention can be applied to the fibrous material by a number of techniques. Fibrous material as used herein is inorganic or organic fibers, fiber tows, woven fabrics, whiskers or particulate fillers such as cellulose. The two most desirable are hot melt coating and solvent coating techniques. The resulting uncured materials are prepregs. The prepregs are arranged into desired shapes and cured to form composite structures.

When the compositions are to be used as adhesives a mixture of the oligomer, aromatic epoxy resin, and hardener are dissolved in a solvent. The viscous solution is then coated onto one of the pieces to be laminated and dried at room temperature for a period of time (about 12-16 hours) and then in an oven for about 2 hours at 70°C. The second piece to be laminated is then placed on top of the epoxy composition and the whole laminate cured.

The thermosetting epoxy resin compositions of this invention are prepared by mixing about 10 to 50 weight percent of an amine, isocyanate, carboxylic acid derivative terminated oligomer or mixture thereof, preferably about 15 to about 30 weight percent, and about 10 to 50 weight percent, preferably about 20 to 45 weight percent, of an aromatic hardener containing diamine or dianhydride groups, and about 30 to 80 percent, preferably about 40 to 75 weight percent, of an aromatic epoxy resin of number average molecular weight below about 500. Optionally a portion of the low molecular weight epoxy resin can be substituted up to about 75 percent of the weight by a higher molecular weight aromatic epoxy resin. Also one to about ten weight percent, preferably about two to five percent, of a functionalized rubber which is reactive with the epoxy resin, hardener, or oligomer can optionally be added. The mixture is blended by stirring the components to give a paste, liquid, or in certain cases a solvent solution. Generally when only the low molecular weight epoxy resin is used a liquid at room temperature results. And, when the higher molecular weight epoxy resin is used, a paste at room temperature but liquid below about 80°C results. If a solvent is used, the mixture is generally about 50 weight percent solids comprising the said preferably range of ingredients, and the solvent is preferably a common organic solvent such as methylene chloride, methylethyl ketone, tetrahydrofuran, diethylether, or other low boiling common organic solvent. If the blend is a dispersion at room temperature, the dispersion is characterized by being a compatible blend of all

ingredients and by being a liquid at some temperature below about 80° C. The epoxy composition is further characterized in that the total carboxylic acid derivative, isocyanate, amine, or combination thereof to epoxy ratio is such that from 0.6 to 1.2, 0.9 to 1.2 preferred, equivalents of active groups from the carboxylic acid derivative, isocyanate or amine groups exist for each equivalent of epoxide groups in the composition.

In the case of adhesives, a higher molecular weight oligomer is generally used. The preferred number average molecular weight is from about 30,000 to about 40,000. In this case the solvent method or preparing the composition is preferred. Also, generally, the composition after the evaporation of the solvent, will be a hard, tacky film.

Useful aromatic epoxy resins of molecular weight below about 500 for the compositions of this inventions are well known in the art and are defined by the general formula (I)

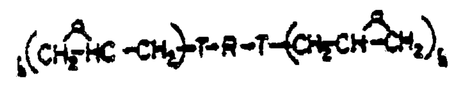

(I)

where R is a divalent aryl, diaryl, or alkylaryl; T is oxygen, nitrogen or ester and can be the same or different, and b is one if T is oxygen or ester and two if T is nitrogen. These compounds are glycidyl derivatives of amines, phenols, amino alcohols, and polycarboxylic acids. Their preparation is well known in the art. The preferred aromatic polyepoxide component contains on the average more than one epoxide group per molecule. The term epoxide group as used herein refers to the simplest epoxide group which is the three membered ring,

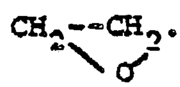

The terms of α-epoxy (or epoxide), 1,2-epoxy (or epoxide), vincinal epoxy (or epoxide) and oxirane group are also art recognized terms for this epoxide group. Particularly useful amine derivatives which are useful in this invention are N,N-diglycidylaniline, N,N-diglycidyl toluidine, N,N,N′,N′-tetraglycidylxylylene diamine, N,N,N′,N′-tetraglycidyl-4,4′-diaminodiphenyl methane, N,N,N′,N′-tetraglycidyl-3,3′-diaminodiphenyl sulfone, N,N′-dimethyl-N,N′-diglycidyl-4,4′-diaminodiphenyl methane and N,N,N′,N′-tetraglycidyl-p-bis(4-isopropylideneaniline)-benzene. Commercially available resins of this type include Glyamine 135 and Glyamine 125 (obtained from F.I.C. Corporation, San Francisco, CA), Araldite MY-720 (obtained from Ciby Geigy Corporation), PGA-X and PGA-C (obtained from Sherwin Williams Co. Chicago, IL, and HPT 1071 from Shell Chemical Co., Houston, TX). Particularly useful polyglycidyl adducts derived from amino alcohols include O,N,N-triglycidyl-4-amino phenol, available as Araldite 0500 or Araldite 0510 (obtained from Ciba Geigy Corporation). Also O,N,N-triglycidyl-3-aminophenol may be used. Particularly useful phenol derivative is O,O-diglycidyl-dihydroxyphenylethane available as Epiclon 830 from Dainippon Ink (Japan). Also suitable herein are the glycidyl esters of phthalic acid, isophthalic acid, and terephthalic acid.

The amine hardener can be selected from the aromatic diamine or dianhydride type which has a molecular weight below about 750. The hardener is present in the composition in an amount sufficient to cross-link or cure the composition into a thermoset and is present in an amount which provides from 0.6 to 1.2, 0.9 to 1.2 preferred, equivalents of total reactive groups of the composition per one equivalent of epoxide groups in the composition. Particularly preferred aromatic diamines of this structure are diaminodiphenyl sulfone; diaminodiphenyl sulfide; 4,4′-methylenedianiline, or other preferred aromatic diamines are such diamines as 2,6-diaminopyridine; 2,4-toluenediamine; and dianisidine.

The aromatic dianhydride hardeners which are preferred in this invention can be chosen from formula (V) above where $R^2$, $R^3$, $R^4$, and $R^5$ are independently hydrogen, halogen or an alkyl or alkoxy group with 1 to 12 carbon atoms, a dihydroxybenzene, or a dihydroxy heterocyclic group and Z is -O-, -S-, $-SO_2-$, -CO-, alkylene, alkylidene, and oxoalkylene c is 0 or 1.

Particularly useful dianhydrides of this formula are 3,3′,4,4′-benzophenonetetracarboxylic acid dianhydride, 2,2-bis(3,4-benzene dicarboxylic acid anhydride perfluoropropane; 2,2-bis (3,4-dicarboxyphenyl) propane. Other dianhydrides which are useful in this invention are 2,3,6,7-naphthalene tetracarboxylic acid dianhydride, 2,2′,3,3′-diphenyltetracarboxylic acid dianhydride and the like.

The amine, isocyanate, acid, anhydride, or acid chloride terminated imide, amide, or amideimide

oligomers of this invention are prepared by procedures generally known by one skilled in the art. Briefly, these oligomers are made in a one step process. Imide, amide or amideimide oligomers with amine, isocyanate or acid derivative terminal groups are prepared from specific amines or isocyanates and anhydride, acid, acid chloride or anhydride-acid chloride or acids by choosing the proper mole ratio and mixing the diamine or mixture thereof or diisocyanate or mixture thereof with dianhydride; diacid chloride or diacid; or anhydride-acid chloride or acid mixture thereof. The diisocyanates are reacted only with dianhydrides. The resulting amine, isocyanate, anhydride, acid, acid chloride or mixture thereof terminated oligomer is then added to the compositions of this invention.

In the preferred embodiments of this invention, when said oligomer is an imide oligomer, the dianhydride is chosen so that at least 30 mole percent of one or more of the following dianhydrides is incorporated into the backbone of the imide oligomer: 3,3′,4,4′-benzophenonetetracarboxylic acid dianhydride, 2,2-bis(3,4-benzene dicarboxyphenyl)propane dianhydride, 2,2-bis(3,4-benzene dicarboxylic acid anhydride) perfluoropropane, bis(3,4-dicarboxyphenyl)ether dianhydride, 4,8-dimethyl-1,2,3,5,6,7-hexahydronaphthalene-1,2,5,6-tetracarboxylic acid dianhydride, 2,2-bis(2,3-dicarboxylphenyl)propane dianhydride, 1,1-bis(2,3-dicarboxylphenyl)ethane dianhydride, 1,1-bis(3,4-dicarboxyphenyl)ethane dianhydride, bis(2,3-dicarboxylphenyl)methane dianhydride, bis(3,4-dicarboxylphenyl)methane dianhydride, 5-(2,5-dioxotetrahydro-3-furanyl-3-cyclohexene-1,2-dicarboxylic anhydride. The type of anhydride which can be used in combination with the already mentioned anhydride are: pyromellitic dianhydride, 2,3,6,7-naphthalene tetracarboxylic acid dianhydride, 1,2,5,6-naphthalene tetracarboxylic acid dianhydride, 2,2′,3,3′-diphenyltetracarboxylic acid dianhydride, 3,4,9,10-perylenetetracarboxylic acid dianhydride, naphthalene-3,4,5,8-tetracarboxylic acid dianhydride, and 3,3′,4,4′-diphenyltetracarboxylic acid dianhydride.

In the preferred embodiments of this invention, when the oligomer is an amide, the acids or acid chlorides which are preferred are: isophthaloyl dichloride, terphthaloyl dichloride, phthaloyl dichloride, naphthaloyl dichlorides, anthraloyl dichlorides, pyridine dicarboxylic acid dichloride, biphenyloyl dichlorides, isophthalic acid, terephthalic acid, phthalic acid, naphthoic dicarboxylic acids, anthralic dicarboxylic acids, pyridine dicarboxylic acid, biphenyl dicarboxylic acids, stilbene dicarboxylic acids, diphenylsulfone dicarboxylic acids, diphenylether dicarboxylic acids, diphenylsulfideddicarboxylic acids, azodiphenyldicarboxylic acids, 2,2-diphenylhexafluoropropane dicarboxylic acids.

In the preferred embodiments of this invention, when the oligomer is an amideimide, the preferred anhydride acid chloride is trimellitic acid anhydride acid chloride and the preferred dianhydrides, diacids or diacid chlorides can be chosen from those already mentioned as preferred materials.

The diamines which are preferred for the incorporation into the polyimide, amide, and amideimide oligomers of this invention are represented by the materials of formulas VI, VII, VIII, and IX above.

The more preferable diamine is p-bis(4-isopropylidene-2,6-dimethylaniline)benzene. Preferable diamines are 4,4′-isopropylidene di-2,6-xylidene, 4,4′-p-phenylenediidopropylidene dianiline,1-(4-aminophenyl)-2,3-dihydro)-1,3,3-trimethyl-1H-indenamine, 2,4-diaminomesitylene. This list is not meant to be all encompassing of the diamine useful in this invention but to demonstrate those materials which are preferred in this invention. In addition, it is known that isocyanates can replace the amine in reaction with dianhydrides to give imides which would have structures identical to those described herein, except that, when an excess of diisocyanate is used, oligomers with isocyanate end groups are formed. Isocyanates which are useful are materials where isocyanate groups replace the amine groups of the preferred amines mentioned above. The amine reaction described here is to provide the preferred process of preparing the oligomers of this invention.

When an excess of diamine mixture to dianhydride; diacid chloride or diacid; anhydride-acid chloride or acid or mixture thereof are reacted, an oligomer containing amine end groups results. When an excess of diisocyanate to dianhydride is reacted, an oligomer containing isocyanate end groups results. When an excess of dianhydride; diacid or diacid chloride; or anhydride-acid chloride or acid, or mixture thereof to diamine are reacted, an oligomer containing anhydride, acid, acid chloride, or anhydride-acid chloride or acid end groups results. When an excess dianhydride to diisocyanate is reacted, an oligomer containing anhydride end groups results. The resulting oligomer, whether it has amine end groups, isocyanate end groups or carboxylic acid derivative end groups or mixtures thereof, can be added to a composition containing an amine or dianhydride aromatic epoxy hardener. In the preferred embodiments of this invention, it is preferred that the end groups of the oligomer be the same as the group of the epoxy hardener; that is when amine end groups exist on the oligomer an amine epoxy hardener is used, and when carboxylic acid derivatives exist on the oligomer a dianhydride hardener is used. However, since the number of end groups on the oligomer is small, it is possible to use an amine or isocyanate terminated oligomer with an aromatic dianhydride epoxy hardener or a carboxylic acid derivative terminated oligomer with an aromatic amine epoxy hardener. In these cases it is possible for the oligomer and hardener to react

with one another, whereas in the preferred embodiments of the invention, the hardener and aromatic epoxy hardener do not react together. In the case where the oligomer end groups and aromatic epoxy hardener groups are different it is still the preferred embodiment of this invention that the total anhydride and carboxlic acid derivative and amine or both to epoxy ratio be such that from 0.9 to 1.2 equivalents of active groups from the anhydride, carboxylic acid derivative, amine, isocyanate or combination thereof of groups exist for each equivalent of epoxide groups in the composition.

When a higher molecular weight oligomer is desired, as for example in the use for adhesives, an equimolar ratio of diamine or diisocyanate to anhydride, acid, acid chloride, anhydride-acid chloride, or anhydride-acid mixture is used. The end groups of the oligomer can thus comprise a combination of the amine, isocyanate, or acid derivative used.

The functionalized rubbers which are useful in this invention are well known in the art. They can be of two types, solid or liquid. The rubbers generally have a number average molecular weight of about 3,000 to about 100,000. The solid rubbers are generally not soluble, but dispersed in the epoxy resin composition. Generally, in this dispersion process, the functionalized rubber is dissolved in a solvent such as methylene chloride or methyl ethyl ketone at about 20 to about 50 weight percent solids and added to the compositions of this invention and the solvent is then evaporated at about 60° to about 100° C.

The liquid rubbers generally are soluble in the epoxy thermosetting compositions of this invention. The functional groups on the rubbers which are useful for the compositions of this invention are those which react with the epoxy resin, epoxy hardener, or oligomer in the thermosetting composition. Such groups as carboxylic acids, amines, epoxide, alcohols, or mercaptans are useful groups. Generally it is preferably that the reactive groups be terminal groups, although functionalized rubbers which have the groups positioned along the backbone of the polymeric chain are useful. Functionalized rubbers which are particularly useful are carboxy terminated butadienes such as Hycar CTBN (B.F. Goodrich Co., Akron, OH). Other functionalized rubbers which are useful in this invention are carboxylic acid, amine, alcohol, or mercaptan terminated stryene-butadienes, acrylonitrile-butadienes, ethylene-propylene-diene monomers, ethylene-propylene rubbers, silicones, hydrogenated polybutadienes, polyisobutylenes, acrylics, epoxyacrylics, and the like. Generally the rubber is added to the composition at about 1 to about 10 weight percent with the preferable range being about 5 to about 7 percent and the amount of total epoxy equivalent is adjusted to account for the small amount of equivalents of reactive groups on the functionalized rubber to give the preferred range of 0.9 to about 1.2 equivalents of reactive groups to equivalents of epoxy group.

Also in place of the functionalized rubber it is possible to disperse about 1 to about 10 percent of a filler such as glass or ceramic in the composition. This dispersion is accomplished by stirring the glass or ceramic in the composition at high rate. The addition of such fillers or rubbers generally increases the $K_{Ic}$ value by about 10 to about 30 percent.

The thermosetting resin compositions for use in hot melt coating applications are prepared by mixing at 25 to about 80° about 20 to about 45 weight percent, preferably about 30 to about 40 weight percent of an aromatic epoxy hardener in about 40 to 75 weight percent, preferably about 50 to 60 weight percent of the selected epoxy resins of this invention on about 15 to 30 weight percent, preferably about 20 to about 25 weight percent of an amide, imide or amideimide oligomer of this invention. In certain embodiments of this invention, it is desirable to combine the above components in such a manner that only a portion of the oligomer and hardener are dissolved in the composition and the remaining portion is dispersed. Upon standing and curing, this dispersed material dissolves and reacts in a short period of time. This procedure is generally used where prepreg tack is desirable. The resulting dispersion or solution is heated to about 60° C to about 100° C for coating purposes. If a rubber or filler is to be added, then the mixing procedure for incorporating the rubber is that previously described.

The thermosetting resin compositions for use in solution coating applications are prepared by dissolving the above mentioned ingredients in the proportions described in a low boiling, common organic solvent such as methylene chloride, acetone, methyl ethyl ketone, tetrahydrofuran, or the like at about a 50% solids level. The solution is then applied to the fabric, fiber, or filler and the solvent evaporated in the case of composite applications. Or, in the case of adhesive applications, the solution is applied to one substance of a laminate and the solvent evaporated and a second substance of a laminate is applied to the composition in order to form a substance #1/composition/substance #2 sandwich.

The prepregs of this invention comprise about 20 to about 50 weight percent, preferably about 25 to about 40 weight percent, of the thermosetting compositions herein described and about 50 to about 80 weight percent, preferably about 60 to about 75 weight percent of a fibrous material such as high strength fiber such as glass, boron, polyamide, polyetherether ketone or carbon, or filler such as cellulose, silica, and the like, which are coated with the thermosetting compositions as a hot melt or solution using processing conditions known in the art.

A preferred manner of making the prepregs of this invention when the fibrous material is carbon fiber is by hot melt coating. This coating method is characterized by impregnating bands of fabrics of continuous fiber with the thermosetting composition in molten form. Generally for hot melt processing it is preferred to have a liquid which has a viscosity of about 10,000 to about 350,000 centipoises (cps) at about 50° to 100° C, more preferably a viscosity between about 30,000 and about 100,000 cps at 100° C.

A preferred method of making the prepregs of this invention when the fibrous material is a glass fabric of woven nature is by solvent coating. In this process the glass woven fabric is passed through a solution of the thermosetting composition in a common organic solvent such as 1,1,1 trichloroethane, methylene chloride, tetrahydrofuran, methylethylketone or the like at about 50 weight percent solids and a viscosity of about 100 to about 1000 cps. The coated fiber is then passed through an oven at preferably about 150 to about 200° C for a residence time of two to three minutes to remove the solvent. The resulting coated fiber is used to make composites.

Other processing techniques can be used to form the prepregs of this invention. For example filament winding, solvent coating, and pultrusion are typical processing techniques in which the thermosetting compositions of this invention can be used. When the fibrous material exists as bundles or when particulate fillers are used, the fibers or fillers can be coated with the thermosetting compositions, and layed up by filament winding or formed in a mold or be pressed into a sheet depending on the particular end use application.

The thermosetting resin compositions for use in adhesive applications are prepared by mixing in solution, preferably methylene chloride, about 10 to about 45 weight percent, preferable about 30 to about 40 weight percent of an aromatic hardener and 15 to 75 weight percent, preferable about 50 to about 60 weight percent of an aromatic epoxy resin having at least two epoxy groups per molecule, and about 15 to about 30 weight percent, preferable about 20 to about 25 weight percent of an amide, imide, or amideimide oligomer of a number average molecular weight of about 3000 to about 50,000, preferable about 20,000 to about 40,000, of this invention. The solution is generally about fifty percent solid in nature. The resulting solution is coated onto either a metal foil or sheet or polymer surface. Preferably a polyimide polymer is used. The film is dried to remove solvent. Then, the same or opposite material described above, i.e. a polymer, preferable a polyimde film, or metal foil or sheet, preferably copper, is placed on top of the dried adhesive film and the resulting laminate is cured at about 180° C for two hours and at about 230° C for two hours under a pressure of about 10 psi. The resulting laminates, preferably of copper foil and polyimide polymer film, have peel strengths of three pounds per inch width or greater.

The composites of this invention are prepared by stacking layer upon layer of the fiber prepregs where applicable, or by placing the coated filler or fiber in a mold. In the case where the fiber is carbon fiber the layup is preferably cured at 180° C for two hours under vacuum at about 80 psi, then at 230° C for two hours under free standing conditions, then at 250° C for five hours under free standing conditions. The resulting composites have a $T_g$ greater than 200°, have excellent toughness, that is a $K_{IC}$ of greater than 1, have a post impact compression (PIC) value higher than 20 Ksi at 1000 lbs impact level and have good solvent resistance. When the fiber is glass, the layup is preferably cured at about 175° C under about 40 to about 80 Ksi pressure with or without the presence of vacuum, then at about 220° C to about 240° C for 4 to 6 hours under free standing conditions.

The preferred thermosetting compositions are comprised of compositions which when cured produce resinous systems which are characterized by multiphase morphology comprising at least two glassy phases at least one of which is a discontinuous phase and one a continuous phase. This latter description is defined as phase separated morphology. The cured resins are insoluble at room temperature in conventional solvents such as jet fuel, hydraulic fuel, acetonitrile, acetone, toluene, methylene chloride, water and the like.

The preferred crosslinked thermosetting composition of this invention when carbon fiber is the fiber of choice are also characterized by a $T_g$ of at least 150° C and preferably above 200° C and a fracture toughness of at least 0.8 $MPam^{1/2}$ (where MPa is megapascals and m is meters). The more preferred crosslinked resins for this application have a fracture toughness of 1.0 $MPam^{1/2}$ or greater and a cohesive fracture energy, $G_{IC}$, of at least 200 $j/m^2$ (where J is joules and m is meters). The preferred composites when the fiber is carbon fiber have a post impact compression (PIC) at an impact energy of 1500 inch-pounds per inch thickness of at least about 20 and more preferably at least about 30 ksi, as determined according to NASA publication 1092, using 32 ply quasiisotropic laminates.

The following test procedures were employed in determining fracture energies ($G_{IC}$) and critical stress intensity factors ($K_{IC}$) of the cured resins produced from the compositions of this invention. The mechanical strength of the cured resins was quantified in terms of the mode I cohesive fracture energy, $G_{IC}$ in $j/m^2$ or the mode I critical stress intensity factor, $K_{IC}$ in megapascals (MPa) times meters (m) to the one half power

($MPam^{1/2}$). The two are related through the following well known relationship which may be found in Fundamentals of Fracture Mechanics by J.F. Knott, Buttersworth, London (1973).

$K_{IC} = (G_{IC}E)^{1/2}$

where E is Young's modulus, determined in accordance with ASTM D638. $G_{IC}$ or $K_{IC}$ can be quantified via numerous test methods such as compact tension, double cantilever beam, double torsion and single edge notch. The cured resins were tested herein using a double torsion fraction test as described in Fracture of Engineering Brittle Materials, Ayal de S. Jayatilaka, Applied Science Publishers Ltd., London (1979).

In carrying out the test, the resin was cast in a 0.125 inch thick panel and the panel milled to yield a number of 1.75 inch by 5 inch by 0.125 inch rectangular bars. A 45 degree diamond-coated saw blade was used to cut a 0.042 inch deep groove down the center of the rectangular bar on both sides. At 0.75 inch from one end, the groove depth on both sides is gradually increased such that the remaining thickness at that end in the center of the grooves is near zero. A pre-crack about 0.75 inch long from the near zero thickness edge is formed by wedging a sharp razor blade into the groove at the end where the thickness between the grooves ($T_c$) is near zero. This specimen is called a double torsion bar.

The double torsion bar sample is placed into a screw driven INSTRON® equipped with a compression load cell and a bottom compression platen. The double torsion bar rests on two rollers on the compression platen with the length axis of the bar parallel to the rollers. The bar is positioned such that the groove is equidistant from the rollers and that the front end is the end with the near zero remaining thickness. The rollers lay in small depressions in the platen and raise the sample by about 0.15 to 0.2 inch above the platen thus allowing the bar to deform in torsion.

The bar is loaded by the downward motion of the crosshead at a rate of 0.05 inch per min. The loading spheres of the INSTRON® hit the top bar surface about 0.25 inch from the front end of the bar. The $P_{IC}$, critical crack propagation load is obtained from the load/time plateau resulting from the load-deflection curve. $K_{IC}$ is calculated by the formula

$$K_{IC} = \sqrt{\frac{3P_{IC}^{2}M^{2}(I + v)}{T_{C}T^{3}W}}$$

where M is the momentum of the torsion which is one-half the distance between the rollers, v is Poisson's ratio which is about 0.35, W is the width of the double torsion bar, T is the double torsion bar thickness, $T_c$ is the thickness of the bar between the center line groove but outside the pre-crack region.

At least three tests were made and the sample mean and standard deviation determined. $G_{IC}$ was then calculated using the previously shown relationship between $G_{IC}$ and $K_{IC}$. The modulus, E was calculated from the shear storage modulus, $G'(\omega)$ assuming Poisson's ratio to be 0.35. ($G'(\omega)$ was determined at $\omega$ = 10 rad/sec and about 22°C with a Rheometrics Mechanical Spectrometer and is reported in gigapascals-(GPa).

To observe the glassy phases of the cured resins and composites prepared using the thermosetting compatible compositions of this invention, carbon fiber composite and neat cured resin samples were thin sectioned at room temperature using a diamond knife. Thin sections (0.6 - 0.8 micron thick) were stained with $RuO_4$ vapor for four minutes before being examined by a transmission electron microscopy (TEM) to determine morphology.

The procedure used for preparing the sections for transmission electron microscopy examination follows. A sample of the cured resin or composite cut to about a 2 x 2 x 10-mm size was placed in a metal chuck and attached to a microtomer (LBK Ultratome V). The sample was prepared for microtoming by first trimming the area to be thin sectioned into the form of a trapezoid using a glass knife. The trapezoidal shaped blockface was less than one millimeter in diameter. The glass knife was replaced with a diamond knife (Sorvall-DuPont) and the trough attached to it was filled with distilled water. As the thin sections (600 to 800 Angstroms) were cut, they were floated in a ribbon pattern on the water surface. The sections were picked up using 300-meshcopper grids and allowed to air-dry. The grids containing the thin sections were attached to a glass microscope slide and placed in a staining dish containing 2% aqueous $RuO_4$ (Aesar) for 4 minutes. The glass slide was removed from the staining dish and the slide was placed under a hood to remove the last traces of any $RuO_4$. The stained microtomed sections were examined using a Zeiss EM-10 transmission microscope at 60 KV and electron photomicrographs were taken at 2000X and 5000X, and

then enlarged to 6000X and 15,000X, respectively.

The glass transition temperature, dry modulus, and wet modulus values of neat cured resin and carbon fiber composite samples were obtained using a Rheometrics Dynamic Spectrometer (RDS). All measurements were made in the temperature sweep mode at a frequency of 10 rad/sec. The strain applied to the torsional rectangular test samples (2.5" x 0.5" x 0.0125") was kept within 0.2% to insure that the measurements were in the linear viscoelastic range. The intersection of the tangents of the slopes of the storage modulus (G′) curve obtained from the RDS's was defined as the glass transition temperature (Tg) of the sample. Using the above procedures, a distinct Tg for each phase of the cured resin is not observed in those cases where the separate phases have Tg's within about 15°C of each other.

The adhesive values for the adhesives of this invention were determined by the 180° Pressure Sensitive Tape Council Peel Adhesion Test PSTC-1.

Molecular weights were determined by size-exclusion chromatography (SEC) using a polystyrene calibration. The samples were chromatographed on a Waters Associates column set consisting of 500A + 500A + $10^4$A $\eta$ Styragel® + 100A Ultrastyragel® columns connected in series. The column set was calibrated with narrow polydispersity polystyrene standards. Tetrahydrofuron was used as the mobile phase. The flow rate was 1.5 ml/min. The samples were dissolved in tetrahydrofuran and the solutions were filtered through a 1.0 $\eta$m membrane filter prior to injection. A differential refractive index detector at ambient temperature was used for peak detection.

Number average molecular weight ($M_n$) was calculated from $W/\Sigma Ni$ where W is weight of all solute species and $N_i$ is the total number of moles. Weight average molecular weight ($M_w$) was calculated from $\Sigma_i M_i W_i / \Sigma_i W_i$ where $W_i$ is the mole fraction of the individual species and $M_i$ is the molecular weight of the species. $M_Z$ molecular weights were calculated from $\Sigma_i N_i M_i^3 / \Sigma_i N_i M_i^2$ where $N_i$ is the number of moles of each species present and $M_i$ is the molecular weight of the species. Polydispersity, $P_i$, is calculated as $M_w$/Mn.

The following examples illustrate this invention but are not meant to limit the scope of the invention. In these examples, unless stated otherwise, all parts and percentages are parts and percentages by weight.

In the above tests the wet values were determined after the sample was immersed in boiling water for 48 hours and kept in water until immediately before running sample.

p-Bis (4-isopropylidene-2,6-dimethylaniline) benzene (EPON HPT 1062): Purchased from Shell Chemical Co. and recrystallized from ethanol at the concentration of 100 parts of the amine to 1000 parts of ethanol.

3,3′,4,4′-Benzophenonetetracarboxylic dianhydride (BTDA): Purchased from Allco was used as received and said to be 99% purity.

2-Methoxyethyl ether (diglyme): Purchased from Aldrich Chemical Co. and dried over 3A molecular sieves.

Toluene: Technical grade toluene was stored over 3A molecular sieve.

Methanol: Technical grade methanol was used as received.

Nitrogen: Nitrogen gas was passed through a 3A molecular sieve and Ridox column before use.

1-Methyl-2-pyrrolidinone (NMP): Spectrophotometric grade was dried over 3A molecular sieve before use.

Also, in the Examples, "SEC" means size exclusion chromatography, "conc" means concentration, "DSC" means differential scanning calorimetry, $M_n$ is number average molecular weight, $M_w$ is weight average molecular weight, $M_Z$ is Z average molecular weight and $P_i$ is molecular weight distribution.

## EXAMPLE 1

### Synthesis of Amine Terminated Polyimide Oligomer

A solution of 3,3′,4,4′-benzophenone tetracarboxylic dianhydride (BTDA, 48.3 parts) and p-bis-(4-isopropylidene-2,6-dimethylaniline) benzene, (available from Shell Chemical Company as Epon 1062, 70.0 parts) in 600 parts of diglyme and 100 parts of toluene was heated at 160° for three hours. After the theoretical amount of water was azeotroped from the reaction mixture, the reaction mixture was cooled to room temperature. The polymer was precipitated in five volumes of methanol, filtered, and washed twice with methanol. After drying in a vacuum oven at 120°C, a light yellow powder was collected (104 parts,

95% yield); $T_g$(DSC) =252° C; $M_n$ =2300; $M_w$ =8700; $M_z$ =15,000.

EXAMPLE 2

Synthesis of Amine Terminated Polyamic/acid Oligomer

To a two liter round bottom flask, p-bis-(4-isopropenylaniline-2,6-dimethylaniline) benzene (70 parts), 400 parts of diglyme, and 90 parts of N-methylpyrridone were added and stirred at room temperature. A solution of 3,3′,4,4′-benzophenone tetracarboxylic dianhydride (BTDA, 48.33 parts) in 40 parts of diglyme were added to the previous mixture. The solution was stirred at 30°-40° C for three hours. The polymer was isolated by pouring the solution into water (solution to water ratio of 1/5) to give an off white solid. The solid was collected by filtration, washed with water, dried in a vacuum oven at 80° C overnight. The off white solid (91.6 parts, 81% yield had a $NH_2$ conc =0.20 meq/g; a COOH conc =2.27 meq/g; $M_n$ =2300; $M_w$ = 10,400; $M_z$ =25,400; and a PI =4.55.

EXAMPLE 3

Synthesis of Amine Terminated Polyamideimide Oligomer

In a two liter three neck flask fitted with a mechanical stirrer, Dean-Stark trap, condenser, nitrogen inlet and a bubbler was added p-bis-(4-isopropylidene-2,6- dimethylaniline) benzene (100 parts) and diglyme (500 parts). The solution was stirred ten minutes at room temperature. Triethylamine (34 parts), trimellitic anhydride acid chloride (47.9 parts) and N-methylpyrridone (300 parts) were added. The reaction was stirred at 40-50° for three hours. Toluene (100 parts) was added and the solution was heated to boiling overnight and the formed water collected by azeotroping. The solution was cooled to 70° C and the polymer collected by pouring the reaction solution into five times the volume of methanol and filtering. The solid was washed with water and then methanol and finally dried in a vacuum oven at 90° to 140° overnight. The white solid (117.8 parts had an amine content of 0.22meq/g; an acid content of 0.1 meq/g; and a $T_g$ of 260° C.

EXAMPLE 4

Carboxylic Acid Derivative-Terminated Polyimide Oligomer

A solution of p-bis-(4-isopropylidene-2,6-dimethylaniline) benzene (60.0 parts) and diglyme (450 parts) was stirred at room temperature for fifteen minutes. A solution of 3,3′,4,4′-benzophenone tetracarboxylic dianhydride (56.4 parts) in 100 parts of diglyme was added. The solution was stirred at 40° to 50° for three hours. Toluene (120 parts) was added to the reaction mixture and the solution heated to boiling overnight and the water formed was azeotroped. The solution was cooled and poured into four volumes of acetic acid to give a pale yellow solid. The solid was filtered and dried in a vacuum oven at 80° C for six hours and at 140° overnight. The 92 parts of white solid had a COOH content of 0.30 meq/g and a $NH_2$ content of 0.01 meq/g.

EXAMPLE 5

Carboxylic Acid Derivative-Terminated Polyamide Oligomer

To a solution of p-bis-(4-isopropylidene-2,6-dimethylaniline) benzene (30 parts), N-methylpyrrolidone (300 parts) and triethylamine (25 parts), was added isophthaloyl dichloride (17.8 parts) in portions such that the reaction temperature did not exceed 50°C. After three hours, the mixture was added to water to precipitate the formed polymer. The polymer was washed with water until no chloride ion was detected (by silver nitrate test) in the wash. After drying at 140°C for four hours, a beige powder was obtained. The polymer had a glass transition temperature of 248°C (DSC method). The end group analysis indicated a $NH_2$(conc.) = 0.01 meq/g and a COOH (conc) of 0.16 meq/g.

EXAMPLE 6

Amine Terminated Polyimide Oligomer

To a solution of 20 parts of a mixture of isomers of diethyldiaminotoluene in 350 parts of diglyme and 100 parts of N-methylpyrrolidine was added 33 parts of 3,3′,4,4′-benzophenone tetracarboxylic dianhydride. The mixture was stirred for two hours. Toluene (100 parts) was added and the mixture was refluxed and dehydrated overnight using a Dean Stark trap. The solution was added to methanol, filtered, and washed with water. After drying in a vacuum oven, 47 parts of a powder were obtained. The oligomer was soluble in methylene chloride and no glass transition temperature below 320°C was found. End group analysis gave: $NH_2$ (conc) = 0.39 meg/g; COOH (conc) = 0.08 meg/g.

EXAMPLE 7

Oligomer and Composition for Adhesive Application

A solution of p-bis-(4-isopropylidene-2,6-dimethylaniline) benzene (200g parts), diglyme (800 parts) and N-methylpyrolidone (200 parts) was stirred in a three liter flask for one-half hour. Benzophenonetetracarboxylic acid anhydride (158 parts) was added in portions and N-methylpyrolidone (500 parts) was used to rinse the weighing container. After three hours, toluene (350 parts) was added and the mixture was refluxed and dehydrated over night using a Dean Stark trap. After cooling to room temperature, the solution was added to methanol. The material was filtered, chopped in water using a Warring blender, and washed with water. After drying in an oven at 140°C for four hours, 332 parts of a beige solid was obtained (98% yield). The material was soluble in methylene chloride. The glass transition temperature by DSC was 282.4°C. The residual amine content was 0.14 meq/g and the residual carboxylic acid content was 0.05 meq/g.

A mixture of the above polymer (5 parts), an aromatic epoxy resin (CG 0510, Ciba-Geigy, 8 parts) and 4,4′-diamino- diphenylsulfone (5 parts) was dissolved in 20 parts of methylene chloride, The viscous solution was coated onto a Kapton® (DuPont) polyimide film and the coating was air dried at room temperature for 16 hours, The coating was then dried in an oven at 70°C for two hours. A copper foil was laminated to the adhesive film. The laminate was cured in a hot press at 180°C for two hours and at 230°C for two hours at constant pressure (about 10 psi). The cured laminate was cut into strips 1 inch wide and 4.5 inches long. Peel strengths between 5 and 7 pounds per inch width were observed.

EXAMPLES 8 TO 13 AND COMPARATIVE EXAMPLE 1

General Preparation of Samples

Into a container equipped with a mechanical stirrer containing 40 parts of O, N, N - triglycidyl 4-aminophenol (CGO 510 from Ciba Geigy) heated at 100°C was added the selected terminated oligomer (16.5 parts). The mixture was kept at this temperature for 0.5 hour, after which most of the oligomer was dissolved. Hardener, 4,4′-Diamino diphenylsulfone (25 parts) in these cases, was added and the temperature was raised to 130°C for 15 min. The mixture was degassed in a vacuum oven at 30mm Hg for thirty minutes at a temperature of about 130-140°C and then poured into a mold that had a cavity of 5" x 5" x 0.125". The resin was cured at 100°C (2 hours) and 230°C (3 hours) to give a thermoset plaque. The plaque was cut into proper test specimens for mechanical property analysis.

When the samples were used in fiber matrices, the cooled resin, before curing, from above was applied to Hercules Magnamite® IM-7 carbon fiber via conventional prepregging techniques and 145 type (areal weight 145 grams/meter$^2$) tapes were made therefrom. Layers of the tapes were assembled into laminates and cured via conventional molding/autoclave techniques using a cure cycle of 2 hours at 177°C followed by 2 hours at 200°C under vacuum. The fiber volume was 58 +/-2% of the volume of the laminate. Thirty two ply quasi- isotropic laminates (4" x 6"; $(+45°/+90°/-45°/0°)_{4s}$) were tested for post impact compression at 1500 inch pounds/inch. The test procedure used is described in NASA publication 1092.

Table 1

| | Example 8 | Example 9 | Example 10 | Example 11 | Example 12 | Example 13 | Comparative Example 1 |
|---|---|---|---|---|---|---|---|
| % Oligomer in Composition[1] | 30% Example 1 | 25% Example 1 | 25% Example 2 | 25% Example 3 | 25% Example 4 | 25% Example 6 | 30% Polysulfone Oligomer |
| Aromatic Epoxide/Hardener | CG 0510/DDS[2] | CG 0510/DDS[2] | CG 0510/DDS | CG 0510/DDS | GC 0510/DDS | CG 0510/DDS | CG 0510/DDS[2] |
| K | 1.5 | 1.3 | 1.2 | 1.3 | 1.3 | 1.0 | 1.5 |
| Dry, T G′ °C | 250 | 245 | 245 | 245 | 245 | 250 | 189 |
| Wet, T G′ °C | 210 | 210 | 200 | 210 | 205 | 210 | 155 |
| Wet G′ at 200 °C (Dynem/$cm^2$ ) | 3.5 x $10^9$ | $4x10^{-9}$ | $4x10^{-9}$ | $4x10^{-9}$ | $4x10^{-9}$ | $4x10^{-9}$ | $8x10^8$ |

[1] When prepreg is prepared 70 weight percent carbon fiber and 30 weight percent mixture of oligomer, aromatic epoxy resin, and aromatic hardener is used.
[2] Mixture of epoxide to diaminodiphenylsulfone 1/1 equivalent.

Table 2

| | Example 14 | Comparative Example 3 |
|---|---|---|
| % Oligomer in Composition[1]<br>Aromatic Epoxide/Hardener<br>Rubber<br>$K_{1c}$<br>Dry, T G′ °C<br>Wet, T G′ °C | Oligomer of Example 1-25%<br>CG 0510/DDS<br>CTBN[3]<br>1.5<br>240<br>205 | Oligomer of Example 1-25%<br>CG 0510/DDS[2]<br>---<br>1.3<br>245<br>210 |

[1] When prepreg is prepared 70 weight percent carbon fiber and 30 weight percent mixture of oligomer, aromatic epoxy resin and aromatic hardener is used.
[2] Mixture of epoxide to diamino diphenyl sulfone 1/1 equivalent.
[3] Hycar 1472 constituted 4 weight percent of the total resin composition.

TABLE 3

| | Example 15 | Comparative Example 2 |
|---|---|---|
| % Oligomer<br>Epoxy/Hardener Ratio | Oligomer of Example 1-19.6%<br>CG 0510/DDS 1:1 equivalent | Polysulfone oligomer<br>CG 0510/DDS 1:1 equivalent |
| Short Beam Shear (ksi) | | |
| dry<br>wet | 12.3 (265° F)<br>9.6 (265° F) | 9.9 (250° F)<br>7.5 (250° F) |
| 0° Compression Strength $10^3$ psi) | | |
| dry<br>wet | 230 (200° F)<br>200 (200° F) | 185 (200° F)<br>180 (200° F) |

## Claims

1. A thermosetting composition comprising: (A) from about 10 to about 45 weight percent of an aromatic hardener selected from a dianhydride or diamine; (B) about 15 to about 40 weight percent of an amide, imide, or amideimide oligomer having carboxylic acid, anhydride, acid, chloride, isocyanate, or amine end groups or mixtures thereof wherein said oligomer has (i) a number average moleculer weight from about 3000 to about 50,000, (ii) a glass transition temperature of above about 200° C and (iii) is soluble in a combination of (A) and (C); and (C) about 15 to about 75 weight percent of an epoxy resin having at least two epoxy groups per molecule selected from the group consisting of the formula

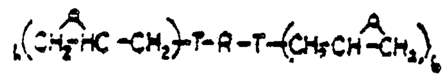

(I)

where R is divalent aryl, diaryl, or alkylaryl; T is oxygen, nitrogen or ester and can be the same or different, and b is one if T is oxygen or ester and two if T is nitrogen wherein the total carboxylic acid derivative, amine or both to epoxy ratio is such that from 0.6 to 1.2 equivalents of active groups from the carboxylic acid, anhydride, acid chloride or amine groups or mixture thereof groups exist for each equivalent of epoxide groups in the composition.

2. A laminate comprising;

(i) a metal foil or sheet;

(ii) a polyimide film; and

(iii) a cured layer of the composition of Claim 1 which is between (i) and (ii), wherein said laminate has a peel strength of three pounds per inch width or greater.

3. A thermosetting composition which is liquid below about 80 °C comprising: (A) from about 10 to about 45 weight percent of a hardener selected from aromatic diamines or dianhydrides; (B) about 15 to about 30 weight percent of an amine, isocyanate or carboxylic acid, anhydride, acid chloride or mixture thereof terminated amide, imide, or amideimide oligomer of number average molecular weight from about 3000 to about 10,000 whose glass transition temperature is above about 200 °C prepared by the reaction of (a) either (i) a diamine or mixture thereof selected from the group consisting of the formulae

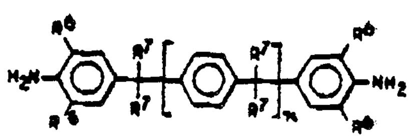

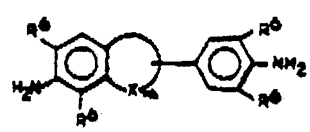

(VI)

(VII)

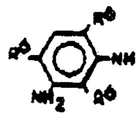

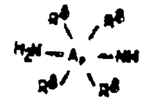

(VIII) (IX)

where $R^6$ is an alkyl, aryl, alkylaryl, halogen, or hydrogen group, $R^7$ is methyl or lower alkyl; n is 0 to 4; X is methylene and m is 3 to 6; Ar is aryl, or alkylaryl and $R^8$ is alkyl, aryl, alkylaryl or halogen and where each amine group in formula IX is bonded to a carbon atom which has each adjacent carbon substituted by $R^8$ and said $R^8$ groups may be the same or different or (ii) a diisocyanate in which an isocyanate group (NCO) replaces each amine group ($NH_2$) in the above formulae; and a dicarboxylic acid derivative or combination thereof selected from the group consisting of the formulae

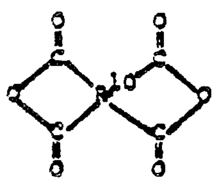

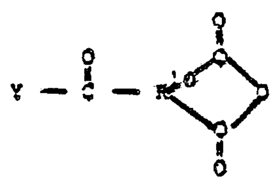

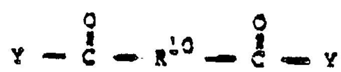

(X) (XI) (XIII)

where $R_{10}$ is aryl, alkylaryl, or diaryl where the aryl groups are connected through a carbon-carbon bond, or through

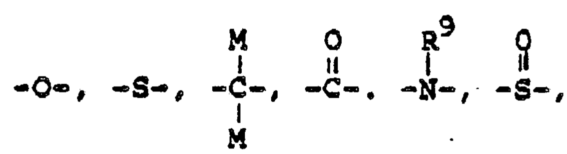

where M is an alkyl or haloalkyl radical, Y is a halogen or hydroxy group and $R^9$ is hydrogen or lower alkyl and the carbonyl groups of the anhydride groups are attached directly to separate carbon atoms and each pair of said carbonyl groups are attached to adjacent carbon atoms in the $R^{10}$ radical: and (C) about 25 to about 75 weight percent of an epoxy having at least two epoxy groups per molecule resin selected from the group consisting of the formula

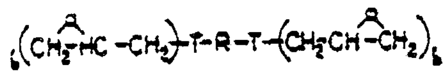

(I)

where R is divalent aryl, diaryl, or alkylaryl; T is oxygen, nitrogen, or ester and can be the same or different, and b is one if T is oxygen or ester and two if T is nitrogen and a portion of said epoxy resin can optionally be selected from a phenolic epoxy resin of formulae

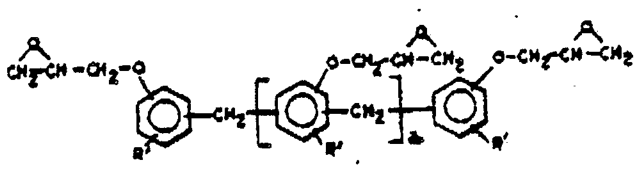

(II)

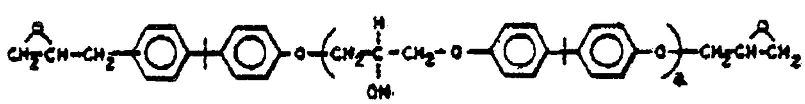

(III)

where a is 0 to 10 and $R^1$ is hydrogen or methyl, such that from 0.6 to 1.2 equivalents of active groups from the amine and carboxylic acid derivative or both groups exist for each equivalent of epoxide groups in the composition.

4. The composition of claim 3 further characterized by the addition of about one to about ten percent of a functionalized rubber.

5. The composition of Claim 4 further characterized in that the amine hardener comprises 4,4′-diaminodiphenylsulfone.

6. The composition of Claim 4 further characterized in that the amine, isocyanate or carboxylic acid derivative terminated oligomer comprises a reaction product of p-bis-(4-isopropylidene-2,6-dimethylaniline) benzene and 3,3′,4,4′-benzophenonetetracarboxylic dianhydride.

7. The composition of Claim 4 further characterized in that the amine or carboxylic acid derivative terminated oligomer comprises a reaction product of p-bis-(4-isopropylidene-2,6-dimethylaniline) benzene and trimellitic anhydride acid chloride.

8. The composition of Claim 4 further characterized in that the amine or carboxylic acid derivative terminated oligomer comprises a reaction product of p-bis-(4-isopropylidene-2,6-dimethylaniline) benzene and isophthaloyl dichloride.

9. A composition of Claim 4 further characterized in that the amine, isocyanate or carboxylic acid derivative terminated oligomer comprises a reaction product of 1,3-diaminobenzene and isophthaloyl dichloride.

10. The composite of Claim 1 wherein the cured resin exhibits phase separated morphology.

11. A composite comprising about 50 to about 80 percent fibrous material and about 50 to about 20 percent of a thermosetting epoxy composition comprising an epoxy resin having at least two epoxy groups per molecule, a hardener, and an amide, imide, or amideimide oligomer; and one or more layers of fibers, said composite exhibiting phase separated morphology, a wet glass transition temperature of 175° C or higher and a $K_{IC}$ greater than about 1.0.